# EUROPÄISCHE PATENTSCHRIFT

(11) **EP 0 637 198 B1**
(45) Veröffentlichungstag und Bekanntmachung des Hinweises auf die Patenterteilung: **23.10.1996**
(21) Anmeldenummer: 94111736.8
(22) Anmeldetag: 27.07.1994
(51) Int. Cl.: H05K 7/14, G06F 1/18

(54) **Adapter für Standardflachbaugruppen und Verwendung solcher Adapter an Montagewinkeln für Standardflachbaugruppen und in Geräten mit Standardflachbaugruppen**
Standard circuit boards adaptor and use of the same for an angle-mounting inside apparatus
Adaptateur de cartes standard et son emploi pour le montage en angle et à l'intérieur des appareils

(30) Priorität: 30.07.1993 DE 4325671
(43) Veröffentlichungstag der Anmeldung: 01.02.1995
(73) Patentinhaber: Siemens Nixdorf Informationssysteme AG, 33106 Paderborn (DE)
(72) Erfinder: Weishaupt Werner, Dipl.-Ing., D-86497 Horgau (DE); Stöbrich, Werner, D-86485 Biberbach (DE); Frank, Ralf, Dipl.-Ing., 76877 Offenbach a.d.Queich (DE)
(74) Vertreter: Fuchs, Franz-Josef, Dr.-Ing.

(56) Entgegenhaltungen:
- DE-U- 9 003 253
- IBM TECHNICAL DISCLOSURE BULLETIN., Bd.33, Nr.1B, Juni 1990, NEW YORK US Seiten 413 - 416, XP122945 'Self-retained input/output groundnspring formcircuit devices'

## Beschreibung

Die Erfindung betrifft einen Adapter für Standardflachbaugruppen gemäß dem Oberbegriff des Anspruchs 1 sowie eine Verwendung solcher Adapter an Montagewinkeln für Standardflachbaugruppen und in Geräten mit Standardflachbaugruppen gemäß den Ansprüchen 6 und 7.

Neuerdings werden bei größeren Personalcomputer-Gehäusen die zugehörigen Standardflachbaugruppen z.B. der Größe 1/2 und 1 nebeneinander angeordnet. Der Grund hierfür ist, daß mit dieser Anordnung eine höhere Ausbaufähigkeit erreicht werden kann. Die meisten führenden Hersteller von Personalcomputern verwenden hinsichtlich der Anordnung der einzubauenden Standardflachbaugruppen dasselbe Aufbaukonzept.

Das Aufbaukonzept hat den Nachteil, daß beim Nach- bzw. Umrüsten von Standardflachbaugruppen beispielsweise der Größe 1/2 nach dem Öffnen des Gerätes die Stromversorgung ausgebaut werden muß, um von innen an die Montageschrauben zu gelangen.

Abgesehen vom erhöhten Montage- bzw. Demontageaufwand soll ein Ausbau der Stromversorgung aus Sicherheitsgründen nur von Fachpersonal durchgeführt werden.

Aufgabe der Erfindung ist es daher, eine Maßnahme anzugeben, durch die Standardflachbaugruppen von außerhalb eines Gerätes lösbar eingebaut werden können, so daß bei Nach- bzw. Umrüstungen von Standardflachbaugruppen die Arbeiten ohne Ausbau beispielsweise der Stromversorgung durchgeführt werden können.

Diese Aufgabe wird durch einen Adapter gelöst, der die kennzeichnenden Merkmale des Anspruchs 1 aufweist. Durch den Adapter ist es möglich, eine nach- bzw. umzurüstende Standardflachbaugruppen eines Gerätes von außen lösbar zu befestigen, weil der Befestigungspunkt für einen Montagewinkel einer Standardflachbaugruppe an einen Punkt verlagert wird, an dem das Lösen und Befestigen von außerhalb des Gerätes möglich ist.

Vorteilhafte Ausgestaltungen der Erfindung sind Gegenstand von Unteransprüchen.

Die Aufgabe wird ferner gelöst, wenn Montagewinkel verwendet werden, die mit solchen Adaptern ausgerüstet sind. Schließlich wird die Aufgabe gelöst, wenn in Geräten mit Standardflachbaugruppen solche Adapter verwendet werden. Derartige Geräte haben den Vorteil, daß bei Nach- bzw. Umrüstungen von Standardflachbaugruppen z.B. die Stromversorgung nicht mehr ausgebaut werden muß. Damit ist das Gerät wesentlich wartungsfreundlicher.

Nachfolgend wird die Erfindung anhand einer Zeichnung näher erläutert. Es zeigen
FIG 1 ein offenes Gerät mit einem Adapter gemäß der Erfindung in Draufsicht,
FIG 2 einen Wandabschnitt der Rückseite des Gerätes nach FIG 1 im Bereich des Anschlußfeldes des Gerätes in perspektivischer Darstellung, und
FIG 3 eine Standardflachbaugruppe mit einem Montagewinkel und einem Adapter gemäß der Erfindung.

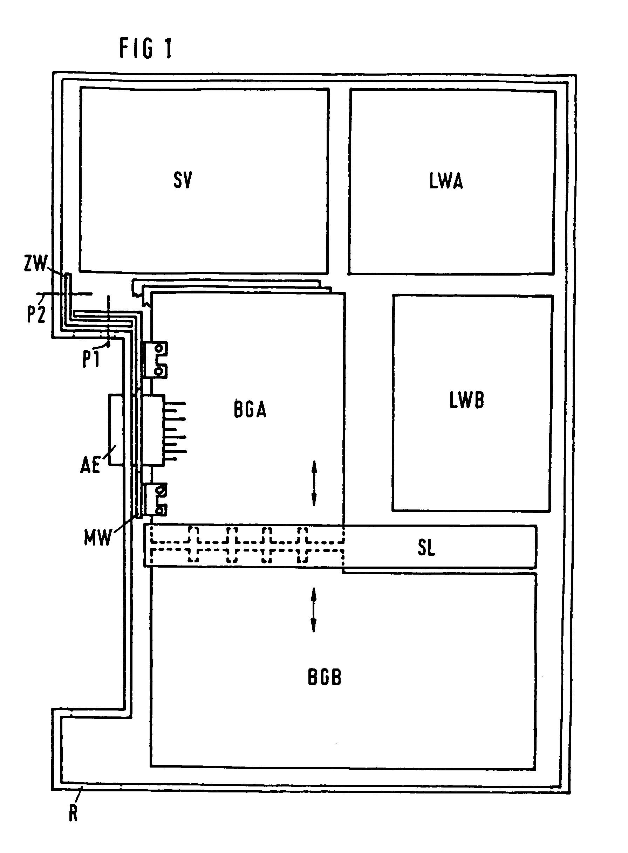

Figur 1 ist eine Draufsicht auf ein offenes Gerät, in dem ein Zusatzwinkel ZW verwendet ist. Der Zusatzwinkel ZW ist ein Adapter zur Befestigung eines Montagewinkels MW für Standardflachbaugruppen BGA. Der Montagewinkel MW wiederum dient zur Befestigung der Standardflachbaugruppen BGA.

Die Standardflachbaugruppe BGA, die gemäß der Figur 1 eine Anschlußeinheit AE aufweist, wird bei der Montage entsprechend der angegebenen Pfeilrichtung in eine Steckerleiste SL eingesteckt. Bei der Demontage wird sie durch eine Bewegung in die entgegengesetzte Richtung aus der Steckerleiste SL herausgezogen.

Der Montagewinkel MW ist an einer zur Steckrichtung der Standardflachbaugruppe BGA seitlichen Stirnkante der Standardflachbaugruppe senkrecht zur Ausdehnungsebene der Standardflachbaugruppe angeordnet und weist einen von der Standardflachbaugruppe weg rechtwinklig abgebogenen Schenkel mit einer Zentrier- und einer Befestigungsaussparung auf.

Ohne den Zusatzwinkel ZW wird der Schenkel des Montagewinkels MW an einer ersten Position P1 in einem Rahmen R des Gerätes befestigt. Dazu ist an einer der Befestigungsaussparung des Schenkels des Montagewinkels MW gegenüberliegenden Stelle im Rahmen R des Gerätes eine Gewindebohrung vorgesehen. Zur Befestigung des Montagewinkels MW und damit der Standardflachbaugruppe BGA greift eine Schraube durch die Befestigungsaussparung des Schenkels des Montagewinkels MW in die Gewindebohrung an der ersten Position P1 im Rahmen R des Gerätes ein.

Neben verschiedenen Laufwerken LWA, LWB und einer zweiten Art von Standardflachbaugruppen BGB weist das in der Figur 1 dargestellte Gerät noch eine Stromversorgung SV auf. Bei den Laufwerken LWA, LWB kann es sich beispielsweise um 5 1/4 Zoll und um 3 1/2 Zoll Laufwerke handeln. Bei der zweiten Art von Standardflachbaugruppen kann es sich um solche handeln, die gemäß einem Nornmaß die Größe 1 aufweisen. Bei den früher angesprochenen Standardflachbaugruppen ist angenommen worden, daß es sich beispielsweise um solche handelt, die gemäß dem Normmaß die Größe 1/2 aufweisen.

Die zweite Art der Standardflachbaugruppen BGB sind in die Steckerleiste SL von einer zweiten Seite her eingesteckt. Die Bewegungsrichtung beim Einstecken und Herausziehen sind durch einen weiteren Doppelpfeil markiert.

Aus Platzgründen sind die einzelnen Komponenten dicht gedrängt innerhalb des Rahmens R des Gerätes angeordnet. Dabei stellt die in der Figur 1 angegebene Anordnung der einzelnen verwendeten Komponenten eine Möglichkeit dar, die heute häufig beispielsweise bei Personalcomputern gewählt wird. Insbesondere ist die Stromversorgung SV in Aussteckrichtung der Standardflachbaugruppe BGA unmittelbar vor diese Standardflachbaugruppe BGA angeordnet mit einem Abstand, der noch ein Ausstecken der Standardflachbaugruppe BGA erlaubt. Wenn auch der Abstand zum Ausstecken der Standardflachbaugruppe BGA reicht, so behindert die Stromversorgung SV aber doch den Zugang zur Schraube, die den Montagewinkel MW der Standardflachbaugruppe BGA befestigt. Zum Lösen der Schraube muß daher zuerst die Stromversorgung herausgebaut werden.

Um dies zu vermeiden, ist gemäß dem Ausführungsbeispiel zwischen dem Schenkel des Montagewinkels MW der Zusatzwinkel ZW angeordnet. Der Zusatzwinkel ZW weist zwei starr im rechten Winkel angeordnete Schenkelflächen auf, von denen bei der Zuordnung zum Schenkel des Montagewinkels MW derart, daß eine Schenkelfläche plan auf dem Schenkel des Montagewinkels MW aufliegt und die andere Schenkelfläche sich in eine die Projektionsfläche des Montagewinkels MW verlängernde Richtung erstreckt, die aufliegende Schenkelfläche an einer der Befestigungsaussparung des Schenkels des Montagewinkels MW gegenüberliegenden Stelle eine erste Gewindebohrung und die nicht aufliegende Schenkelfläche eine zweite Gewindebohrung aufweist. Die erste Gewindebohrung in der Schenkelfläche des Zusatzwinkels ZW kommt damit genau gegenüber der Gewindebohrung an der ersten Position P1 im Rahmen R zu liegen. Bei der Verwendung des Zusatzwinkels ZW ist daher die an der ersten Position P1 im Rahmen R angeordnete Gewindebohrung durch ein vergrößertes Durchgangsloch ersetzt. Ferner ist an der der zweiten Gewindebohrung der die Projektionsfläche des Montagewinkels MW verlängernden Schenkel fläche des Zusatzwinkels ZW gegenüberliegenden Stelle im Rahmen R des Gerätes eine weitere Gewindebohrung angeordnet. In der Figur 1 ist diese Gewindebohrung an der zweiten Position P2 im Rahmen R vorgesehen.

Die Befestigung des Montagewinkels MW erfolgt bei der Verwendung des Zusatzwinkels ZW in der Weise, daß der Schenkel des Montagewinkels MW zuerst mit der die erste Gewindebohrung aufweisenden Schenkel fläche des Zusatzwinkels ZW verbunden wird. Nach dem Einstecken der Standardflachbaugruppe BGA in die Steckerleiste SL zusammen mit dem Montagewinkel MW und dem Zusatzwinkel ZW wird dann die die zweite Gewindebohrung aufweisende Schenkel fläche des Zusatzwinkels ZW mit dem Rahmen R des Gerätes verbunden.

Die letztgenannte Verbindung kann dabei von außerhalb des Gerätes erfolgen. Das vergrößerte Durchgangsloch an der ersten Position P1 im Rahmen R des Gerätes dient dazu, daß die Befestigungsschraube zur Befestigung des Schenkels des Montagewinkels MW mit der betreffenden Schenkel fläche des Zusatzwinkels ZW ungehindert hindurchgreifen kann.

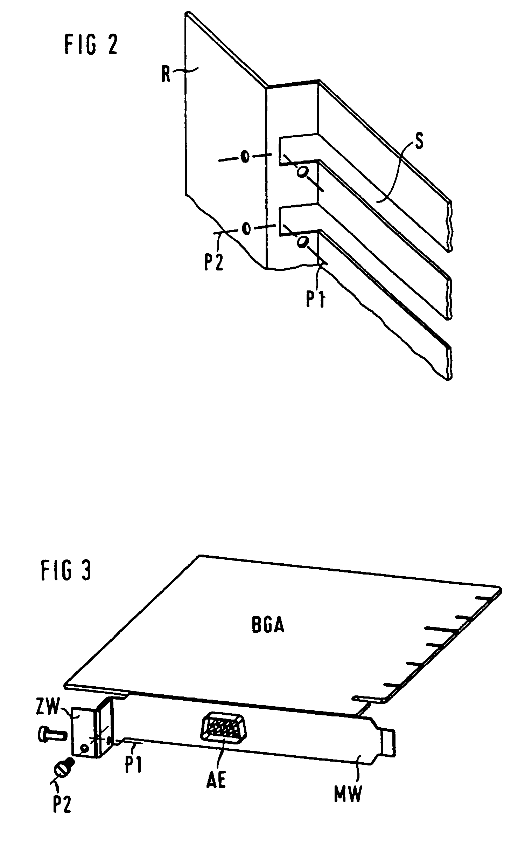

In der Figur 1 sind skizzenhaft noch weitere Standardflachbaugruppen BGA angedeutet. Dies soll verdeutlichen, daß unterhalb der jeweiligen Standardflachbaugruppe noch andere Flachbaugruppen angeordnet sein können. Hierdurch wird eine sehr kompakte Bauweise des Gerätes erzielt. Die Vielzahl der Anschlußeinheiten AE bilden zusammen ein Anschlußfeld, das in der gezeigten Darstellung in einer Einbuchtung des Gerätes ausgebildet ist. Damit die Anschlußeinheiten AE der einzelnen Standardflachbaugruppen mit den Standardflachbaugruppen BGA hin- und hergeschoben werden können, weist der Rahmen R entsprechende Schneisen S auf, die in der Figur 2 zu sehen sind.

In der Figur 3 ist eine einzelne Standardflachbaugruppe BGA mit einem Montagewinkel MW und einem Zusatzwinkel ZW dargestellt. Die Flächenausdehnungen der Schenkelflächen des Zusatzwinkels ZW sind der Flächenausdehnung des Schenkels des Montagewinkels MW angepaßt. Die erste und zweite Gewindebohrung der beiden Schenkelflächen des Zusatzwinkels ZW, die mit der Angabe der ersten und zweiten Position P1, P2 markiert sind, sind ferner gemäß dem Ausführungsbeispiel auf einer gemeinsamen Höhenlinie angeordnet. Die auf dem Schenkel des Montagewinkels MW aufliegende Schenkelfläche des Zusatzwinkels ZW kann ein Rastelement, beispielsweise eine gestanzte Auswellung, aufweisen, das in die Zentrieraussparung des Schenkels des Montagewinkels MW zur Zentrierung eingreift.

## Patentansprüche

1. Adapter (ZW) für Standardflachbaugruppen (BGA) mit Montagewinkel (MW), der an einer zur Steckrichtung der Standardflachbaugruppe seitlichen Stirnkante der Standardflachbaugruppe senkrecht zur Ausdehnungsebene der Standardflachbaugruppe angeordnet ist und einen von der Standardflachbaugruppe weg rechtwinklig abgebogenen Schenkel mit einer Zentrier- und einer Befestigungsaussparung aufweist,
**gekennzeichnet durch**
zwei starr im rechten Winkel angeordnete Schenkel flächen, von denen bei einer Zuordnung zum Schenkel des Montagewinkels derart,
daß eine Schenkel fläche plan auf dem Schenkel des Montagewinkels (MW) aufliegt und die andere Schenkel fläche sich in eine die Projektionsfläche des Montagewinkels (MW) verlängernde Richtung erstreckt, die aufliegende Schenkelfläche an einer der Befestigungsaussparung des Schenkels des Montagewinkels (MW) gegenüberliegenden Stelle eine erste Gewindebohrung und die nicht aufliegende Schenkel fläche eine zweite Gewindebohrung aufweist.

2. Adapter nach Anspruch 1,
**dadurch gekennzeichnet,**
daß die Flächenausdehnung der beiden Schenkelflächen der Flächenausdehnung des Schenkels des Montagewinkels (MW) angepaßt ist.

3. Adapter nach Anspruch 1 oder 2,
**dadurch gekennzeichnet,**
daß die erste und die zweite Gewindebohrung der beiden Schenkelflächen auf einer gemeinsamen Höhenlinie angeordnet sind.

4. Adapter nach einem der vorherigen Ansprüche,
**dadurch gekennzeichnet,**
daß die aufliegende Schenkel fläche an einer der Zentrieraussparung des Schenkels des Montagewinkels (MW) gegenüberliegenden Stelle ein in die Zentrieraussparung greifendes Rastelement aufweist.

5. Adapter nach Anspruch 4,
**dadurch gekennzeichnet**,
daß das Rastelement durch eine Auswellung gebildet ist.

6. Verwendung eines Adapters gemäß einem der Ansprüche 1 bis 5 zusammen mit einem Montagewinkel für Standardflachbaugruppen als Einzelelement.

7. Verwendung eines Adapters gemäß einem der Ansprüche 1 bis 5 in einem Gerät mit Standardflachbaugruppen, denen Montagewinkel zugeordnet sind, die an einer zur Steckrichtung der Standardflachbaugruppe seitlichen Stirnkante der Standardflachbaugruppe senkrecht zur Ausdehnungsebene der Standardflachbaugruppe angeordnet sind und einen von der Standardflachbaugruppe weg rechtwinklig abgebogenen Schenkel mit einer Zentrier- und einer Befestigungsaussparung aufweisen, wobei an einer der Befestigungsaussparung des Schenkels des Montagewinkels (MW) zugeordneten Stelle in einem Rahmen (R) des Gerätes eine dort angeordnete Gewindebohrung als vergrößertes Durchgangsloch ausgebildet und an einer der zweiten Gewindebohrung des Adapters gegenüberliegenden Stelle im Rahmen (R) des Gerätes eine weitere Gewindebohrung vorgesehen ist.

## Claims

1. Adapter (ZW) for standard printed circuit board assemblies (BGA) having a mounting bracket (MW), which is arranged on a lateral end edge (with respect to the insertion direction of the standard printed circuit board assembly) of the standard printed circuit board assembly perpendicular to the plane in which the standard printed circuit board assembly extends, and which has a limb which is bent off at right angles away from the standard printed circuit board assembly and has a centring and a fastening cutout, characterized by two limb surfaces, which are arranged rigidly at right angles and of which, given an assignment to the limb of the mounting bracket in such a way that one limb surface rests in a planar manner on the limb of the mounting bracket (MW) and the other limb surface extends in a direction which lengthens the projected area of the mounting bracket (MW), the resting limb surface has a first threaded hole at a point opposite the fastening cutout of the limb of the mounting bracket (MW) and the non-resting limb surface has a second threaded hole.

2. Adapter according to Claim 1, characterized in that the surface area of the two limb surfaces is matched to the surface area of the limb of the mounting bracket (MW).

3. Adapter according to Claim 1 or 2, characterized in that the first and the second threaded hole of the two limb surfaces are arranged at a common level.

4. Adapter according to one of the preceding claims, characterized in that the resting limb surface has a latching element, which engages into the centring cutout, at a point opposite the centring cutout of the limb of the mounting bracket (MW).

5. Adapter according to Claim 4, characterized in that the latching element is formed by a convex projection.

6. Use of an adapter according to one of Claims 1 to 5 together with a mounting bracket for standard printed circuit board assemblies as an individual element.

7. Use of an adapter according to one of Claims 1 to 5 in a device having standard printed circuit board assemblies, to which are assigned mounting brackets which are arranged on a lateral end edge (with respect to the insertion direction of the standard printed circuit board assembly) of the standard printed circuit board assembly perpendicular to the plane in which the standard printed circuit board assembly extends, and which have a limb which is bent off at right angles away from the standard printed circuit board assembly and has a centring and a fastening cutout, a threaded hole arranged at a point in a rack (R) of the device, which point is assigned to the fastening cutout of the limb of the mounting bracket (MW), being designed at the said point as an enlarged through hole, and a further threaded hole being provided in the rack (R) of the device at a point opposite the second threaded hole of the adapter.

## Revendications

1. Adaptateur (ZW) pour des plaques (BGA) à circuit imprimé standard comportant une cornière (MW) de montage, qui est montée sur un bord frontal, latéral par rapport à la direction d'enfichage de celle-ci, de la plaque à circuit imprimé standard, et perpendiculairement au plan dans lequel s'étend la plaque à circuit imprimé standard et qui comporte une branche coudée à angle droit s'éloignant de la plaque à circuit imprimé standard et comportant un évidemment de centrage et un évidemment de fixation,
caractérisé par
deux surfaces de branches disposées rigidement à angle droit, parmi lesquelles, lors d'une association à la branche de la cornière de montage, de manière qu'une surface de branche s'appuie de manière plane sur la branche de la cornière (MW) de montage et que l'autre surface de branche s'étende dans une direction prolongeant la surface de projection de la cornière (MW) de montage, la surface de branche en appui comporte en un endroit faisant face à l'évidemment de fixation de la branche de la cornière (MW) de montage, un premier taraudage et la surface de branche non en appui comporte un second taraudage.

2. Adaptateur suivant la revendication 1,
caractérisé en ce que,
l'étendue des deux surfaces des branches est adaptée à l'étendue de la surface de la branche de la cornière (MW) de montage.

3. Adaptateur suivant la revendication 1 ou 2,
caractérisé en ce que
le premier et le second taraudages des deux surfaces des branches sont prévus à une hauteur commune.

4. Adaptateur suivant l'une des revendications précédentes,
caractérisé en ce que
la surface de branche un appui comporte, en un endroit faisant face à l'évidemment de centrage de la branche de la cornière (MW) de montage, un élément d'encliquetage s'engageant dans l'évidemment de centrage.

5. Adaptateur suivant la revendication 4,
caractérisé en ce que
l'élément d'encliquetage est formé d'une ondulation.

6. Utilisation d'un adaptateur suivant l'une des revendications 1 à 5 conjointement avec une cornière de montage pour des plaques à circuit imprimé standard en tant qu'élément individuel.

7. Utilisation d'un adaptateur suivant l'une des revendications 1 à 5 dans un appareil comportant des plaques à circuit imprimé standard, auxquelles sont associées les cornières de montage, lesquelles cornières sont montées sur un bord frontal de la plaque à circuit imprimé standard, latéral par rapport à la direction d'enfichage de celle-ci et perpendiculairement au plan dans lequel s'étend la plaque à circuit imprimé standard, et lesquelles comportent une branche coudée à angle droit, s'éloignant de la plaque à circuit imprimé standard et comportant un évidemment de centrage et un évidemment de fixation, un taraudage prévu en un endroit du cadre (R) de l'appareil, associé à l'évidemment de fixation de la branche de la cornière (MW) de montage étant formé en cet endroit en tant que trou de passage agrandi et un autre taraudage étant prévu en un endroit du cadre (R) de l'appareil faisant face au second taraudage de l'adaptateur.
